# EUROPEAN PATENT APPLICATION

(11) **EP 4 369 013 A1**
(43) Date of publication of application: **15.05.2024**
(21) Application number: 23764216.0
(22) Date of filing: 16.03.2023
(51) Int. Cl.: G01R 31/367, G01R 31/382, G01R 31/3842, B60L 3/00, B60L 58/10

(54) **METHOD AND SYSTEM FOR EARLY WARNING OF ABNORMAL SELF-DISCHARGE OF BATTERY, AND ELECTRONIC DEVICE AND STORAGE MEDIUM**

(30) Priority: 21.09.2022 CN 202211154244
(71) Applicant: Voyah Automobile Technology Company Ltd., Hanyang District Wuhan City, Hubei 430050 (CN)
(72) Inventor: WANG, Yongshi, Wuhan, Hubei 430050 (CN); XIE, Hui, Wuhan, Hubei 430050 (CN); ZHU, Jinxin, Wuhan, Hubei 430050 (CN); HUANG, Min, Wuhan, Hubei 430050 (CN); LIU, Zhenyong, Wuhan, Hubei 430050 (CN); WANG, Junjun, Wuhan, Hubei 430050 (CN); LU, Fang, Wuhan, Hubei 430050 (CN); ZHANG, Shutao, Wuhan, Hubei 430050 (CN); LIU, Kai, Wuhan, Hubei 430050 (CN); SHEN, Jian, Wuhan, Hubei 430050 (CN)
(74) Representative: Sach, Greg Robert
(86) International application number: PCT/CN2023/081831
(87) International publication number: WO 2024/060537

(57) **Abstract**

The present invention provides a method, system, electronic device, and storage medium of pre-warning for abnormal self-discharge of battery. The method includes: acquiring multiple extreme values of single-cell voltage, multiple extreme values of state-of-charge of single-cell and a time interval of adjacent data within a current working condition cycle of a vehicle battery system, based on a working condition information, a structural information and a consistency information of the vehicle battery system; calculating a self-discharge capacity, a self-discharge energy and an average self-discharge current value of the vehicle battery system based on the extreme values of single-cell voltage, the extreme values of state-of-charge of single-cell and the time interval of adjacent data; judging whether the vehicle battery system is self-discharged according to whether any one of the self discharge capacity, the self-discharge energy and the average self-discharge current value is greater than a preset threshold value; performing a pre-warning of battery safety based on a judgment result.

## Description

### CROSS-REFERENCE TO RELATED APPLICATIONS

The application claims a priority of the Chinese patent application No. 202211154244.6, filed on September 21, 2022, and titled "Method, system, electronic device and storage medium of pre-warning for abnormal self discharge of battery", which is incorporated herein by reference in its entirety.

### TECHNICAL FIELD

The present invention relates to a technical field of battery, and more specifically, to a method, system, electronic device, and storage medium of pre-warning for abnormal self-discharge of battery.

### BACKGROUND

The battery management system (BMS) is a control system that ensures the safety of power battery in use, monitors a status of use of a battery at all times and alleviates an inconsistency of cell-group by certain measures to provide a guarantee for the safety of new energy vehicles.

The power battery used in new energy vehicles is a battery system composed of a plurality of secondary batteries connected in series and parallel. There are problems such as a thermal runaway and a consistency deterioration for the battery. One of main causes for the thermal runaway of the battery or the consistency deterioration of the battery is a self-discharge of the battery. The main reasons for the self-discharge of the battery include a micro-short circuit caused by external factors, a micro-short circuit caused by internal factors in the battery, or an energy consumption caused by intense secondary reactions inside the battery. Therefore, how to further effectively improve accuracy of a pre-warning for a self-discharge of a vehicle battery system is an urgent problem to be solved.

### SUMMARY

The present invention, aiming at technical problems existing in the prior art, provides a method, system, electronic device and storage medium of pre-warning for abnormal self-discharge of battery. The problem on how to further effectively improve the accuracy of the pre-warning for a self-discharge of a vehicle battery system is solved by utilizing one or more embodiments of the present invention.

According to a first aspect of the present invention, a method of pre-warning for abnormal self-discharge of battery is provided, including:
acquiring multiple extreme values of single-cell voltage, multiple extreme values of state-of-charge of single-cell and a time interval of adjacent data within a current working condition cycle of a vehicle battery system, based on a working condition information, a structural information and a consistency information of the vehicle battery system;
calculating a self-discharge capacity, a self-discharge energy and an average self-discharge current value of the vehicle battery system based on the extreme values of single-cell voltage, the extreme values of state-of-charge of single-cell and the time interval of adjacent data;
judging whether the vehicle battery system is self-discharged according to whether any one of the self discharge capacity, the self-discharge energy and the average self-discharge current value is greater than a preset threshold value;
performing a pre-warning of battery safety based on a judgment result.

According to a second aspect of the present invention, a system of pre-warning for abnormal self-discharge of battery is provided, including:
a state acquisition module, configured for acquiring multiple extreme values of single-cell voltage, multiple extreme values of state-of-charge of single-cell and a time interval of adjacent data within the current working condition cycle of a vehicle battery system, based on a working condition information, a structural information and a consistency information of the vehicle battery system;
a data calculation module, configured for calculating a self discharge capacity, a self discharge energy and an average self-discharge current value of the vehicle battery system based on the extreme values of single-cell voltage, the extreme values of state-of-charge of single-cell and the time interval of adjacent data;
a systematic judgment module, configured for judging whether the vehicle battery system is self-discharged according to whether any one of the self discharge capacity, the self-discharge energy and the average self-discharge current value is greater than a preset threshold value;
a safety pre-warning module, configured for performing a pre-warning of battery safety based on a judgment result.

According to a third aspect of the present invention, an electronic device is provided, including a memory and a processor, and the processor, when executing a computer management program stored in the memory, is configured to implement steps of any method of pre-warning for abnormal self-discharge of battery in the first aspect.

According to a fourth aspect of the present invention, a computer-readable storage medium is provided, on which a computer management program is stored, and the computer management program when executed by a processor, implements steps of any method of pre-warning for abnormal self-discharge of battery according to the fist aspect.

The present invention provides a method, system, electronic device, and storage medium of pre-warning for abnormal self-discharge of battery. The method includes: acquiring multiple extreme values of single-cell voltage, multiple extreme values of state-of-charge of single-cell and a time interval of adjacent data within the current working condition cycle of a vehicle battery system, based on a working condition information, a structural information and a consistency information of the vehicle battery system; calculating a self discharge capacity, a self discharge energy and an average self-discharge current value of the vehicle battery system based on the extreme values of single-cell voltage, the extreme values of state-of-charge of single-cell and the time interval of adjacent data; judging whether the vehicle battery system is self-discharged according to the self-discharge capacity, the self-discharge energy and the average self-discharge current value; performing a pre-warning of battery safety based on a judgment result. A pre-warning for a self-discharge of a vehicle battery system under different working conditions, different battery structures, and different states of consistency of all single-cells is realized by the present invention by calculating the self discharge capacity, the self-discharge energy and the average self-discharge current value of a vehicle battery system based on the working condition information, the structural information and the consistency information of the vehicle battery system, and by judging whether the vehicle battery system is self-discharged based on the self-discharge capacity, the self discharge energy and/or the average self-discharge current value, thereby a safety of the vehicle battery system and a user experience of passengers are greatly improved.

### BRIEF DESCRIPTION OF DRAWINGS

FIG. 1 shows a flowchart of a method of pre-warning for abnormal self-discharge of battery according to some embodiments of the present invention;
Fig. 2 shows a schematic structural diagram of a system of pre-warning for abnormal self-discharge of battery according to some embodiments of the present invention;
FIG. 3 shows a schematic diagram of a hardware structure of an electronic device according to some embodiments of the present invention; and
FIG. 4 shows a schematic diagram of a hardware structure of a computer-readable storage medium according to some embodiments of the present invention.

### DESCRIPTION OF EMBODIMENTS

The technical solutions of the present invention will be further described in detail below in conjunction with the accompanying drawings and embodiments. The following embodiments are used to illustrate the content of the present invention, but not to limit the scope of the present invention.

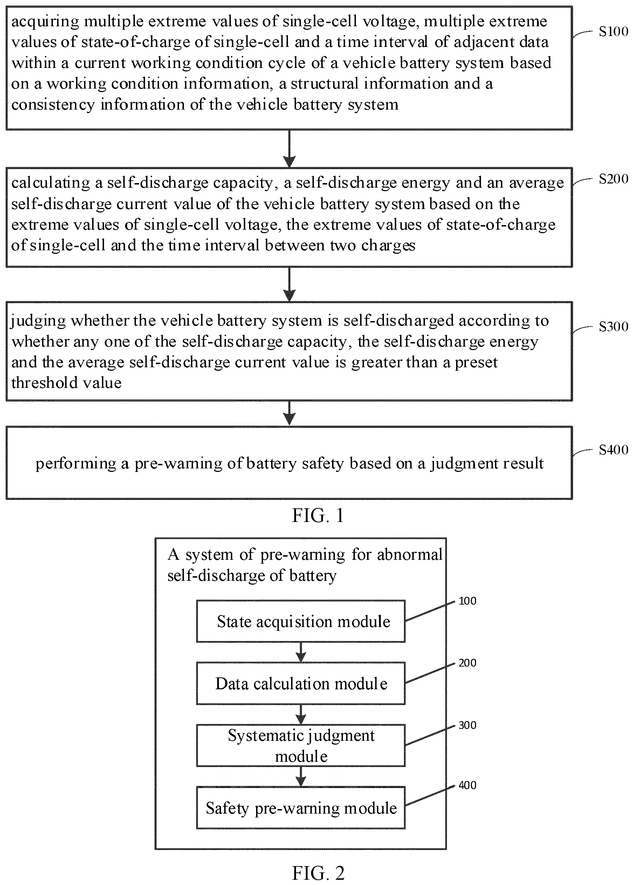

FIG. 1 is a flowchart of a method of pre-warning for abnormal self-discharge of battery provided by the present invention. As shown in FIG. 1, the method includes:
Step S100: acquiring multiple extreme values of single-cell voltage, multiple extreme values of state-of-charge of single-cell and a time interval of adjacent data within a current working condition cycle of a vehicle battery system based on a working condition information, a structural information and a consistency information of the vehicle battery system.

It should be noted that, in some embodiments, a subject for the execution of the method may be a computer terminal device such as a computer, a tablet computer, and so on with functions of data processing, network communication and program running; it may also be a server device with same and similar functions, or further can also be a cloud server with the similar functions, and is not limited in the present invention. For ease of understanding, the server device is taken as an example to illustrate some embodiments of the present invention.

It can be understood that the working condition information may include a charging working condition, a discharging working condition and a resting working condition of the battery system. The structural information may be that cell-groups are made up of an individual cell and various cell-groups are connected in series therebetween, or cell-groups are made up of a plurality of cells and various cell-groups are connected in series therebetween. The consistency information may be a state of consistency of all single-cells in the battery system. The state of consistency includes an idealized state and a non-idealized state.

It should be understood that the current working condition cycle may refer to a period of time during which the battery system is in a current working condition state and the corresponding data is obtained, i.e., the current working condition cycle may refer to a working condition cycle, during which the corresponding data of the battery system is obtained.

It can also be understood that the time interval of adjacent data may refer to a collection time interval of data for multiple extreme values of single-cell voltage and multiple extreme values of state-of-charge of single-cell, and time intervals among all data can be acquired through the time interval of adjacent data.

In Step S200: a self discharge capacity, a self-discharge energy and an average self-discharge current value of the vehicle battery system are caculated based on the extreme values of single-cell voltage, the extreme values of state-of-charge of single-cell and the time interval of adjacent data.

In Step S300: whether the vehicle battery system is self-discharged is judged according to whether any one of the self discharge capacity, the self-discharge energy and the average self-discharge current value is greater than a preset threshold value.

It can be understood that a condition that any one of the self discharge capacity, the self-discharge energy and the average self-discharge current value is greater than a preset threshold value, can indicate that the current battery system is self-discharged. The preset threshold value may be 0. A user can choose one or more of the self-discharge capacity, the self-discharge energy and the average self-discharge current value as a judgment condition according to an actual use requirement, which is not limited in the present invention.

Step S400: a pre-warning of battery safety is performed based on a judgment result.

It can be understood that the present invention proposes a method of pre-warning for abnormal self-discharge of battery based on defects in the background technology. The method includes: acquiring multiple extreme values of single-cell voltage, multiple extreme values of state-of-charge of single-cell and a time interval of adjacent data within the current working condition cycle of a vehicle battery system, based on a working condition information, a structural information and a consistency information of the vehicle battery system; calculatinga self discharge capacity, a self discharge energy and an average self-discharge current value of the vehicle battery system based on the extreme values of single-cell voltage, the extreme values of state-of-charge of single-cell and the time interval of adjacent data; judging whether the vehicle battery system is self-discharged according to whether any one of the self discharge capacity, the self-discharge energy and the average self-discharge current value is greater than a preset threshold value; and performing a pre-warning of battery safety based on a judgment result. A pre-warning for a self-discharge of a vehicle battery system under different working conditions, different battery structures, and different states of consistency of all single-cells is realized in the present invention by calculating the self-discharge capacity, the self-discharge energy and the average self-discharge current value of a vehicle battery system based on the working condition information, the structural information and the consistency information of the vehicle battery system, and by judging whether the vehicle battery system is self-discharged based on the self discharge capacity, the self-discharge energy and/or the average self-discharge current value, thereby a safety of the vehicle battery system and a user experience of passengers are greatly improved.

In some embodiments, a step of calculating a self discharge capacity, a self-discharge energy and an average self-discharge current value of a vehicle battery system based on the extreme values of single-cell voltage, the extreme values of state-of-charge of single-cell and the time interval of adjacent data, includes:
acquiring a first time interval between ends of two charges in the case that the working condition information is a state of end of charge, the consistency information is the idealized state, and the structural information is a single-parallel & multiple-series or multiple-parallel & multiple-series; in some embodiments, the idealized state is that a difference value between a lowest single-cell voltage and a highest single-cell voltage after an end of previous charge is less than or equal to a preset difference value;
acquiring the extreme values of state-of-charge of single-cell after an end of latter charge; in some embodiments the extreme values of state-of-charge of single-cell includes a maximum value of state-of-charge of single-cell and a minimum value of state-of-charge of single-cell;
acquiring a first difference of extrema based on the maximum value of state-of-charge of single-cell and the minimum value of state-of-charge of single-cell after the end of latter charge; and
calculating the self discharge capacity, the self-discharge energy, and the average self-discharge current value of the vehicle battery system according to the first difference of extrema, a rated capacity of single-cell, a rated energy of single-cell, and the first time interval.

In some embodiments, for new energy vehicles in normal operation, the BMS stores a predetermined strategy for charging a battery, which is generally called a battery charging MAP table in the industry, and a charging rate mainly depends on a SOC (State-of-charge) of the battery (equivalent to a battery voltage), and a temperature of the battery.

A battery system with a simplest structure, "single-parallel & multiple-series", is taken as an example. The state of consistency of all single-cells in this battery system is the idealized state, that is, a capacity, an internal resistance, and a polarization internal resistance, etc. as analysis objects are all consistent. It is assumed that that the rated capacity of single-cell is x₁, and the rated energy of single-cell is e₁. It should be noted that the single-parallel & multiple-series may be that all cell-groups are connected in series, while the multiple-parallel & multiple-series may be that a preset number of cells are connected in parallel to form cell-groups, and the cell-groups are connected in series with each other to form a battery system. 100 cells are taken as an example. If it is the single-parallel & multiple-series structure, then all the 100 cells are connected in series. If every two cells are connected in parallel as one cell-group, and the cell-groups are connected in series with each other, that is, 2 single-cells are connected in parallel and a total of 50 cell-groups are formed, and the 50 cell-groups are connected in series with each other. If every five cells are connected in parallel as one cell-group, and the cell-groups are connected in series with each other, thus a total of 20 cell-groups are formed, and the 20 cell-groups are connected in series with each other.

In an application scenario, a highest single-cell voltage Vₘₐₓ₁ and a lowest single-cell voltage Vₘᵢₙ₁ when a first charge ends normally (a charging voltage reaches a cut-off voltage) are taken to calculate the state-of-charges for corresponding single-cells as SOC_{high1} and SOC_{low1} respectively, according to an OCV (Open circuit voltage)-SOC data. Since an assumed analysis object is a battery system in which the states of consistency of all single-cells are the idealized state, then Vₘₐₓ₁ = Vₘᵢₙ₁, and correspondingly SOC_{high1} = SOC_{low1}.

The highest single-cell voltage Vₘₐₓ₂ and the lowest single-cell voltage Vₘᵢₙ₂ when a second charge ends normally (the charging voltage reaches the cut-off voltage) are taken to calculate the state-of-charges for corresponding single-cells as SOC_{high2} and SOC_{low2} respectively, according to the OCV-SOC data.

If after an end of first charge, a certain cell has a problem of self discharge, then this cell will be subject to a self-loss of electric quantity while doing external work, then Vₘₐₓ₂ > Vₘᵢₙ₂, and correspondingly SOC_{high2} > SOC_{low2}. A time interval between ends of two charges is t₁, then within a period of time between the ends of two charges, the electric quantity (capacity) of self-discharge of a self-discharge cell is (SOC_{high2} - SOC_{low2} ) × x₁, the self-discharge energy of the self-discharge cell is (SOC_{high2} -SOC_{low2} ) × e₁, and corresponding average self-discharge current of the self-discharge cell is (SOC_{high2} -SOC_{low2} )× x₁/t₁ during this period of time. It should be noted that in some embodiments (SOC_{high2} - SOC_{low2} ) is a first difference of extrema, and x₁ is the rated capacity of single-cell, e₁ is the rated energy of single-cell, and t₁ is the first time interval.

Correspondingly, it is also possible to take the highest single-cell voltage V_{maxN} and the lowest single-cell voltage V_{minN} when a N^{th} charge ends normally, to calculate the state-of-charges for corresponding single-cells as SOC_{highN} and SOC_{lowN} according to the OCV-SOC data. If a certain cell is self-discharged during a period of time (t_{N}) from the end of first charge to the end of N^{th} charge, then within this period of time, the electric quantity (capacity) of self-discharge of this self discharge cell is (SOC_{highN} - SOC_{lowN} ) × x₁, the self-discharge energy of this self discharge cell is (SOC_{highN} -SOC_{lowN} ) × e₁, and corresponding average self-discharge current of this self-discharge cell is (SOC_{highN} -SOC_{lowN} )× x₁/t_{N} during this period of time.

In another application scenario, a battery system within a module of which two cells are connected in parallel to form one cell-group and the cell-groups are connected in series with each other is taken as an example, the state of consistency of all single-cells in this battery system is the idealized state, that is, the capacity, the internal resistance, and the polarization internal resistance, etc. as analysis objects are all consistent. It is assumed that the rated capacity of single-cell is x₁ and the rated energy of single-cell is e₁, then the rated capacity of a cell-group being single-in series(in which two cells connected in parallel) is 2x₁, the rated energy of the cell-group is 2e₁.

In a corresponding first application scenario, it is assumed that the two cells are connected in parallel to form one cell-group, and the battery system in which various cell-group is connected in series with each other is in an ideal state of consistency.

The highest single-cell voltage Vₘₐₓ₁ and the lowest single-cell voltage Vₘᵢₙ₁ when the first charge ends normally (the charging voltage reaches the cut-off voltage) are taken to calculate the state-of-charges for corresponding single-cells as SOC_{high1} and SOC_{low1} respectively, according to the OCV-SOC data. Since an assumed analysis object is a battery system in which the states of consistency of all single-cells are the idealized state, then Vₘₐₓ₁ = Vₘᵢₙ₁, and correspondingly SOC_{high1} = SOC_{low1}.

The highest single-cell voltage Vₘₐₓ₂ and the lowest single-cell voltage Vₘᵢₙ₂ when a second charge ends normally (the charging voltage reaches the cut-off voltage) are taken to calculate the state-of-charges for corresponding single-cells as SOC_{high2} and SOC_{low2} respectively, according to the OCV-SOC data.

If a certain cell has a problem of self discharge after the end of first charge, then this cell will be subject to the self-loss of electric quantity while doing external work, then Vₘₐₓ₂ > Vₘᵢₙ₂, and correspondingly SOC_{high2} > SOC_{low2}. The time interval between ends of two charges is t₁, then within a period of time between the ends of two charges, the electric quantity (capacity) of self-discharge of a self-discharge cell is (SOC_{high2} - SOC_{low2}) × 2x₁, the self-discharge energy of the self-discharge cell is (SOC_{high2} -SOC_{low2} ) × 2e₁, and corresponding average self-discharge current of the self-discharge cell is (SOC_{high2} -SOC_{low2} )× 2x₁/t₁ during this period of time.

Correspondingly, it is also possible to take the highest single-cell voltage V_{maxN} and the lowest single-cell voltage V_{minN} when a N^{th} charge ends normally, to calculate the state-of-charges for corresponding single-cells as SOC_{highN} and SOC_{lowN} according to the OCV-SOC data. If a certain cell is self-discharged during a period of time (t_{N}) from the end of first charge to the end of N^{th} charge, then within this period of time, the electric quantity (capacity) of self-discharge of this self discharge cell is (SOC_{highN} - SOC_{lowN} ) × 2x₁, the self-discharge energy of this self discharge cell is (SOC_{highN} -SOC_{lowN} ) × 2e₁, and corresponding average self-discharge current of this self discharge cell is (SOC_{highN} -SOC_{lowN} )× 2x₁/t_{N} during this period of time.

In another application scenario, a plurality of cells in the module are connected in parallel (assuming that cells, the number of which is a, are connected in parallel) to form one cell-group, and the cell-groups are connected in series with each other, and the rated capacity of each cell-group (in which cells, the number of which is a, are connected in parallel) is axi and the rated energy of each cell-group is aei. Results of the above five cases are multiplied by times of a. A result of the first application scenario should be changed to: (SOC_{high2} - SOC_{low2}) × ax₁.

In another application scenario, the BMS reports a data of a cloud platform. The data may, in addition to the highest single-cell voltage Vₘₐₓ, the lowest single-cell voltage Vₘᵢₙ, further include an average single-cell voltage Vₘₑₐ. Therefore in the above cases, Vₘₑₐ is used instead of Vₘₐₓ to improve a stability of the calculations.

In some embodiments, the method of pre-warning for abnormal self-discharge of battery further includes:
acquiring a second time interval between the ends of two charges, in the case that the working condition information is the state of end of charge, the structural information is the single-parallel & multiple-series, and the consistency information is a non-idealized state; in some embodiments, the non-idealized state is that a difference value between the lowest single-cell voltage and the highest single-cell voltage after an end of previous charge is greater than a preset difference value;
acquiring a difference value between the minimum values of state-of-charge of single-cell after the end of previous charge and after the end of latter charge as a second difference of extrema; and
calculating the self discharge capacity, the self-discharge energy, and the average self-discharge current value of the vehicle battery system according to the second difference of extrema, the rated capacity of single-cell, the rated energy of single-cell, and the second time interval.

In an application scenario, a highest single-cell voltage Vₘₐₓ₁ and a lowest single-cell voltage Vₘᵢₙ₁ after a first charge is observed to be ended normally are taken to calculate the state-of-charges for corresponding single-cells as SOC_{high1} and SOC_{low1} respectively, according to an OCV-SOC data. If the consistency information of the battery system is the non-idealized state at this time, then Vₘₐₓ₁ > Vₘᵢₙ₁, and correspondingly SOC_{high1} > SOC_{low1}.

The highest single-cell voltage Vₘₐₓ₂ and the lowest single-cell voltage Vₘᵢₙ₂ after the second charge is observed to be ended normally are taken to calculate the state-of-charges for corresponding single-cells as SOC_{high2} and SOC_{low2} respectively, according to the OCV-SOC data. Vₘₐₓ₂ > Vₘᵢₙ₂, and correspondingly SOC_{high2} > SOC_{low2}.

The time interval between the ends of two charges is t₁. Because a cut-off voltage of charge is controlled by a charging strategy of the BMS, therefore in principle Vₘₐₓ₁ = Vₘₐₓ, and correspondingly SOC_{high1}= SOC_{high2}.

If Vₘᵢₙ₁ = Vₘᵢₙ₂, and correspondingly SOC_{low1} = SOC_{low2}, then within the time interval t₁, there are no cells with the problem of self discharge.

If Vₘᵢₙ₁ >Vₘᵢₙ₂, and correspondingly SOC_{low1} > SOC_{low2}, then within a period of timet₁, there are cells with the problem of self discharge. The electric quantity (capacity) of self-discharge is (SOC_{low1} - SOC_{low2}) × x₁, the self-discharge energy is (SOC_{low1} - SOC_{low2}) × e₁, and the average self-discharge current is ( SOC_{low1} - SOC_{low2}) × x₁/t₁. It should be noted that in some embodiments (SOC_{low1} - SOC_{low2}) is a second difference of extrema, and x₁ is the rated capacity of single-cell, e₁ is the rated energy of single-cell, and t₁ is the second time interval.

Correspondingly, it is also possible to take the highest single-cell voltage V_{maxN} and the lowest single-cell voltage V_{minN} when a N^{th} charge ends normally, to calculate the state-of-charges for corresponding single-cells as SOC_{highN} and SOC_{lowN} according to the OCV-SOC data. The time interval between the ends of two charges is t_{N}. Because the cut-off voltage of charge is controlled by the charging strategy of the BMS, in principle Vₘₐₓ₁ = V_{maxN}, and correspondingly SOC_{high1}= SOC_{highN}.

If Vₘᵢₙ₁ =V_{minN}, and correspondingly SOC_{low1} = SOC_{lowN}, then within a period of time t _{N}, there are no cells with the problem of self-discharge.

If Vₘᵢₙ₁ >V_{minN}, and correspondingly SOC_{low1} > SOC_{lowN}, then within a period of time t_{N}, there are cells with the problem of self discharge. The electric quantity (capacity) of self discharge is (SOC_{low1} - SOC_{lowN} ) × x₁, the self discharge energy is (SOC_{low1} - SOC_{lowN}) × e₁, and the average self-discharge current is ( SOC_{low1} - SOC_{lowN} ) × x₁/t_{N}.

In some embodiments, polarization internal resistances of the battery are inconsistent, therefore, in order to eliminate an influence on a SOC estimation of a battery caused by a polarization in the process of charging, a voltage value after the battery is rested for a period of time after the charging is completed normally is taken each time. A resting time can be 10 minutes, 20 minutes, 30 minutes, 60 minutes, 90 minutes, or 120 minutes. Generally, the longer the resting time, the better the effect of depolarization of the cell, and the more accurate the judgment of the self-discharge of the cell, but the smaller probability of a data that can be acquired by a real vehicle. Therefore in practical applications, a trade-off should be made between a length of the resting time and the probability of a data that can be acquired by the real vehicle.

The highest single-cell voltage Vₘₐₓ₁ and the lowest single-cell voltage Vₘᵢₙ₁ after the end of first charge and the battery is rested for a period of time are taken to calculate the state-of-charges for corresponding single-cells as SOC_{high1} and SOC_{low1} respectively, according to the OCV-SOC data.

The highest single-cell voltage Vₘₐₓ₂ and the lowest single-cell voltage Vₘᵢₙ₂ after the end of second charge and the battery is rested for a period of time are taken to calculate the state-of-charges for corresponding single-cells as SOC_{high2} and SOC_{low2} respectively, according to the OCV-SOC data. The time interval between the ends of two charges is t₁.

According to the charging strategy of the BMS, the cut-off voltage of charge is constant, but a corresponding highest single-cell voltage after a battery is rested is lower than the cut-off voltage of charge due to a influence of the polarization in the process of charging.

It is assumed that Vₘₐₓ₁ = Vₘₐₓ₂, and correspondingly SOC_{high1} = SOC_{high2}, the electric quantity (capacity) of self-discharge of the self-discharge cell is (SOC_{low1} - SOC_{low2}) × x₁, the self-discharge energy of the self-discharge cell is (SOC_{low1} - SOC_{low2}) × e₁, and the average self-discharge current of the self-discharge cell is (SOC_{low1} - SOC_{low2}) × x₁/t₁.

In some other embodiments, in order to eliminate influences of uncertain factors such as a polarization (assuming that Vₘₐₓ₁ ≠ Vₘₐₓ₂, and correspondingly SOC_{high1} ≠SOC_{high2}), the highest single-cell voltage is taken as a reference object, then the electric quantity (capacity) of self-discharge of the self-discharge cell is ((SOC_{low1} -SOC_{low2} ) - (SOC_{high1} -SOC_{high2}) ) × x₁, the self-discharge energy of the self-discharge cell is ((SOC_{low1} -SOC_{low2}) - (SOC_{high1} -SOC_{high2} )) × e₁, and the average self-discharge current of the self-discharge cell is ((SOC_{low1} -SOC_{low2} ) -(SOC_{high1} -SOC_{high2} )) × x₁/t₁.

In some embodiments, it is also possible to take the highest single-cell voltage V_{maxN} and the lowest single-cell voltage V_{minN} when a N^{th} charge ends normally, to calculate the state-of-charges for corresponding single-cells as SOC_{highN} and SOC_{lowN} according to the OCV-SOC data. The time interval between the ends of two charges is t_{N}. In order to eliminate the influences of the polarization (assuming that Vₘₐₓ₁ ≠ V_{maxN}, and correspondingly SOC_{high1} ≠SOC_{highN}), the highest single-cell voltage is taken as a reference object, then the electric quantity (capacity) of self-discharge of the self-discharge cell is ((SOC_{low1} -SOC_{lowN} ) - (SOC_{high1} -SOC_{highN}) ) × x₁, the self-discharge energy of the self-discharge cell is ((SOC_{low1} -SOC_{lowN}) - (SOC_{high1} -SOC_{highN} )) × e₁, the average self-discharge current of the self-discharge cell is ((SOC_{low1} -SOC_{lowN} ) -(SOC_{high1} -SOC_{highN} )) × x₁/t₁.

At the same time, with the use of the battery the battery will decay accordingly, and a retention rate/a SOH (state of health) of the capacity for the battery will drop from 100% of a new battery to a certain value. Then the electric quantity of self-discharge, the self-discharge energy, and a self discharge current of the battery calculated in the above two cases should be multiplied by corresponding SOH.

In some embodiments, it is also possible to judge the self discharge condition of a target vehicle based on a big data statistics technology. In some embodiments, in order to improve the accuracy of a data calculation and a probability of taking an available data, it is also possible not to rely on a depolarization process after charging. Due to a fixed charging strategy of the BMS, at a final period of a charging, the battery is in a trickle charging mode, i.e. the battery is charged at a fixed small rate for a period of time. Therefore, based on the big data statistics technology, an amplitude of voltage drop b of a single-cell with highest voltage and the amplitude of voltage drop c of a single-cell with lowest voltage brought by the depolarization of this model of battery (which has been used for a certain cycle life, and been rested for a certain period of time (the period of time can be from 10 minutes to 120 minutes, and can be counted respectively) after the end of this trickle charging mode), are obtained and are substituted into formulas of the above several conditions to obtain the self-discharge capacity, the self-discharge energy and the average self-discharge current. In some embodiments, at the end of first charge, the highest single-cell voltage is Vₘₐₓ₁, and the lowest single-cell voltage is Vₘᵢₙ₁, therefore an equivalent depolarization highest single-cell voltage is (Vₘₐₓ₁ - b), and an equivalent depolarization lowest single-cell voltage is (Vₘᵢₙ₁ - c), on the basis of which an OCV-SOC data sheet is looked up to obtain the SOC_{high1} and the SOC_{low1} accordingly. At the end of second charge, the highest single-cell voltage is Vₘₐₓ₂, and the lowest single-cell voltage is Vₘᵢₙ₂, therefore an equivalent depolarization highest single-cell voltage is (Vₘₐₓ₂ - b), and an equivalent depolarization lowest single-cell voltage is (Vₘᵢₙ₂ - c), on the basis of which the OCV-SOC data sheet is looked up to obtain the SOC_{high2} and the SOC_{low2} accordingly. Then the electric quantity (capacity) of self-discharge of the self-discharge cell is ((SOC_{low2} -SOC_{low2} ) - (SOC_{high1} -SOC_{high2}) ) × x₁, the self-discharge energy of the self-discharge cell is ((SOC_{low1} -SOC_{low2}) - (SOC_{high1} -SOC_{high2} )) × e₁, and the average self-discharge current of the self-discharge cell is ((SOC_{low1} -SOC_{low2} ) -(SOC_{high1} -SOC_{high2} )) × x₁/t₁.

In some embodiments, the method of pre-warning for abnormal self-discharge of battery further includes:
acquiring a third time interval between the ends of two charges in the case that the working condition information is a state of discharge, the consistency information is the idealized state, and the structural information is a single-parallel & multiple-series;
acquiring the extreme values of state-of-charge of single-cell after an end of latter charge;
acquiring a third difference of extrema based on the maximum value of state-of-charge of single-cell and the minimum value of state-of-charge of single-cell after the end of latter charge; and
calculating the self discharge capacity, the self-discharge energy, and the average self-discharge current value of the vehicle battery system according to the third difference of extrema, the rated capacity of single-cell, the rated energy of single-cell, and the third time interval.

In one application scenario, especially for extended-range vehicles or hybrid vehicles, only if the SOC of the power battery will be reduced to a set value such as 20%, and then a driving charging mode will be turned on. In this way, there will be a fixed low SOC state, therefore better conditions for comparing a low-end state of the battery with the fixed low SOC state for identifying the problem of self discharge is created. Certainly, it can also compare data at ends of any two discharges. Since a lithium iron phosphate battery has an obvious plateau period, there is a large error about the corresponding SOC calculated according to the voltage, then it is recommended that data in an interval range within which the SOC is below 30% is preferred for calculation.

The highest single-cell voltage, when a set-SOC is arrived during the first charge, is Vₘₐₓ₁, and corresponding SOC state is SOC_{high1}. The lowest single-cell voltage, when the set-SOC is arrived during the first charge, is Vₘᵢₙ₁, and corresponding SOC state is SOC_{low1}. The highest single-cell voltage are taken as the reference object in all the above steps, and if there is the average single-cell voltage, then the average single-cell voltage V ₘₑₐ₁ and corresponding SOC ₘₑₐ₁ are preferentially used as the reference objects.

The highest single-cell voltage and the lowest single-cell voltage, when the set-SOC is arrived during the second charge, is Vₘₐₓ₂ and Vₘᵢₙ₂, and corresponding SOC state is SOC_{high2} and SOC_{low2}, then the highest single-cell voltage is taken as the reference object. The time interval between ends of two discharges is t₁.

In the case that the battery system is a battery in the idealized state, Vₘₐₓ₁ = Vₘᵢₙ₁ at the end of first discharge, and correspondingly SOC_{high1} = SOC_{low1}. If the battery has the problem of self-discharge after the end of first discharge and before the end of second discharge, then Vₘₐₓ₂ > Vₘᵢₙ₂, and correspondingly SOC_{high2} = SOC_{low2}. Then within a period of time between ends of two discharges, the self-discharge capacity is (SOC_{high2} - SOC_{low2}) × x₁, the self discharge energy is (SOC_{high2} - SOC_{low2}) × e₁, and the average self-discharge current is (SOC_{high2} - SOC_{low2} ) × x₁/t₁. It should be noted that in some embodiments (SOC_{high2} - SOC_{low2} ) is a third difference of extrema, and x₁ is the rated capacity of single-cell, e₁ is the rated energy of single-cell, and t₁ is a third time interval.

In some embodiments, if it is a battery system, in which cells, the number of which are a, within the module are connected in parallel to form cell-groups and the cell-groups are connected in series with each other, then the self-discharge capacity, energy, and current of the battery system, need to be multiplied by a sum number a.

In some embodiments, the method of pre-warning for abnormal self-discharge of battery further includes:
acquiring a fourth time interval between the ends of two charges in the case that the working condition information is the state of discharge, the consistency information is the idealized state, and the structural information is a multiple-parallel & multiple-series;
acquiring the extreme values of state-of-charges of single-cells after the ends of two charges;
acquiring a fourth difference of extrema based on the lowest single-cell voltage and the highest single-cell voltage after the end of previous charge;
acquiring a fifth difference of extrema based on the lowest single-cell voltage and the highest single-cell voltage after the end of latter charge;
taking a difference value between the fourth difference of extrema and the fifth difference of extrema as a sixth difference of extrema; and
calculating the self discharge capacity, the self-discharge energy, and the average self-discharge current value of the vehicle battery system according to the sixth difference of extrema, the rated capacity of single-cell, the rated energy of single-cell, and the fourth time interval.

In one application scenario, Vₘₐₓ₁ ≠ Vₘᵢₙ₁ at the end of first discharge, and correspondingly SOC_{high1} ≠ SOC_{low1}. If the battery has the problem of self-discharge after the end of first discharge and before the end of second discharge, then Vₘₐₓ₂ > Vₘᵢₙ₂, and correspondingly SOC_{high2} = SOC_{low2}. Then within a period of time between the ends of two discharges, the self-discharge capacity is ((SOC_{low1} -SOC_{low2} ) - (SOC_{high1} -SOC_{high2}) ) × x₁, the self-discharge energy is ((SOC_{low1} -SOC_{low2}) - (SOC_{high1} -SOC_{high2} )) × e₁, and the average self-discharge current is ((SOC_{low1} -SOC_{low2} ) -(SOC_{high1} -SOC_{high2} )) × x₁/Δt₁. It should be noted that in some embodiments (SOC_{low1} - SOC_{low2}) is a fourth difference of extrema, (SOC_{high1} - SOC_{high2} ) is a fifth difference of extrema, x₁ is the rated capacity of single-cell, e₁ is the rated energy of single-cell, and △t₁ is a fifth time interval.

In some embodiments, it is better to analyze a data after the battery is rested for a period of time for depolarization after the discharge.

In some embodiments, the method of pre-warning for abnormal self-discharge of battery further includes:
acquiring a fifth time interval between two resting states within a corresponding period of time which is greater than a preset threshold value for resting duration in the case that the working condition information is the resting state and a resting duration is greater than or equal to the preset threshold value for resting duration;
acquiring the extreme values of state-of-charges of single-cells under the two resting states;
acquiring a seventh difference of extrema based on the lowest single-cell voltage and the highest single-cell voltage in previous resting state;
acquiring a eighth difference of extrema based on the lowest single-cell voltage and the highest single-cell voltage in latter resting state;
taking a difference value between the eighth difference of extrema and the seventh difference of extrema as a ninth difference of extrema; and
calculating the self discharge capacity, the self-discharge energy, and the average self-discharge current value of the vehicle battery system according to the ninth difference of extrema, the rated capacity of single-cell, the rated energy of single-cell, and the fifth time interval.

In one application scenario, there are two advantages for a selection of resting scenarios and an application of resting data: first, the vehicle battery system is powered off and without any power consumption, and a working condition similar to laboratory self discharge detection is created; second, the vehicle battery system being rested with low power consumption, a current being ≤1/20 C (the current by which the battery system is fully discharged for 1 hour is called 1C), are an ideal scenario for eliminating a battery polarization, and can improve the accuracy of calculation for battery self-discharge.

If the vehicle battery system is rested with low power consumption (such as the current ≤ 1/20C) for a long period of time, then the highest single-cell voltage Vₘₐₓ₁, the lowest single-cell voltage Vₘᵢₙ₁, a corresponding state-of-charge SOC_{high1}, SOC_{low1} at a moment t₁ (for a better depolarization, generally t₁ needs to be ≥ 10 minutes, and the preset threshold value for resting duration is ten minutes) are taken; and the highest single-cell voltage Vₘₐₓ₂, the lowest single-cell voltage Vₘᵢₙ₂, and the corresponding state-of-charge SOC_{high2} and SOC_{low2} at a moment t₂ before the end of the resting are taken.

If a certain cell has a problem of self discharge within this resting period of time, then self-discharge capacity of the cell is ((SOC_{high2} -SOC_{low2} )-(SOC_{high1} -SOC_{low1})) × x₁, the self-discharge energy of the cell is ((SOC_{high2} -SOC_{low2} ) - (SOC_{high1} -SOC_{low1} )) × e₁, and the average self-discharge current of the cell is ((SOC_{high2} -SOC_{low2} ) - (SOC_{high1} -SOC_{low1})) × x₁ / (t₂ - t₁). It should be noted that, in some embodiments, an eighth difference of extrema is (SOC_{high2} -SOC_{low2} ), a seventh difference of extrema is (SOC_{high1} - SOC_{low1} ), a ninth difference of extrema is ((SOC_{high2} -SOC_{low2} )-(SOC_{high1} -SOC_{low1} )), x₁ is the rated capacity of the singl-cell, e₁ is the rated energy of the singl-cell, and (t₂ -t₁ ) is a fifth time interval.

In some embodiments, the method of pre-warning for abnormal self-discharge of battery further includes:
Step S500: acquiring an amplitude of voltage drop or a recovery degree of voltage of the extreme values of single-cell voltage of the vehicle battery system with different service lives, different charging rates and different resting durations without power consumption, and judging, based on the amplitude of voltage drop or the recovery degree of voltage, whether the vehicle battery system is self-discharged.

In one application scenario, the vehicle battery system is suddenly powered off from a working condition of high-rate charging and enters a state without power consumption, and after a period of time t₁, the vehicle battery system is powered on again. The highest single-cell voltage is Vₘₐₓ₁ and the lowest single-cell voltage is Vₘᵢₙ₁ before the vehicle battery system is powered off; the highest single-cell voltage is Vₘₐₓ₂, the lowest single-cell voltage is Vₘᵢₙ₂ after the vehicle battery system is powered on again. As the vehicle battery system is charged at a high rate before being powered off, the battery is polarized, and the vehicle battery system is depolarized after being rested for a period of time, then Vₘₐₓ₁ > Vₘₐₓ₂, Vₘᵢₙ₁ > Vₘᵢₙ₂. The amplitude of voltage drop of the single-cell with highest voltage and the amplitude of voltage drop of the single-cell with lowest voltage under different service lives (number of cycles), different charging rates, and different resting durations without power consumption (depolarization time) are counted based on a big data. If it is found that the amplitude of voltage drop of the lowest single-cell voltage for a certain battery system after a certain resting becomes significantly larger, then it is indicated that the cell has the problem of self-discharge.

Example 1, the batteries of 10,000 vehicles after 2 years of use and with a cycle period of 100 weeks are counted by the big data statistics technology. In the case that the batteries are powered off and enter the state without power consumption when being charged at the charging rate of 1C, then the highest single-cell voltage is counted to drop in volts with a number of a, and the lowest single-cell voltage is counted to drop in volts with a number of b after the battery is rested for 60 minutes. However, for the same battery under the same charging working condition and resting working condition, the highest single-cell voltage drops in volts with a number of a, and the lowest single-cell voltage drops by (b+c) volts, then it indicates that the single-cell with lowest voltage has a problem of self-discharge. The SOC corresponding to the voltage drop of c volts is obtained by looking up the OCV-SOC data sheet, then the self-discharge capacity is SOC × x₁, the self discharge energy is SOC × e₁, and the self-discharge current is SOC × x₁/60 min.

Example 2, a certain battery system of a vehicle after 2 years of use and with the cycle period of 100 weeks is counted by the big data statistics technology. In the case that the battery is powered off and enters the state without power consumption when being charged at 1C charging rate, then the highest single-cell voltage is counted to drop in volts with a number of a, and the lowest single-cell voltage is counted to drop in volts with a number of b after the battery is rested for 60 minutes. However, after the battery is rested for 60 minutes under the same working condition, the highest single-cell voltage drops in volts with a number of a, and the lowest single-cell voltage drops by (b+c) volts. It indicates that the single-cell with lowest voltage has the problem of self-discharge. The SOC corresponding to the voltage drop of c volts is obtained by looking up the OCV-SOC data sheet, then the self-discharge capacity is SOC × x₁, the self-discharge energy is SOC × e₁, and the self-discharge current is SOC × xi/60 min.

In another application scenario, the vehicle battery system is suddenly powered off from a working condition of high-rate discharging and enters a state without power consumption. After a period of time t₁, the vehicle battery system is powered on again. The highest single-cell voltage is Vₘₐₓ₁ and the lowest single-cell voltage is Vₘᵢₙ₁ before the vehicle battery system is powered off; the highest single-cell voltage is Vₘₐₓ₂, the lowest single-cell voltage is Vₘᵢₙ₂ after the vehicle battery system is powered on again. As the vehicle battery system is discharged at a high rate before being powered off, the battery is polarized, and the vehicle battery system is depolarized after being rested for a period of time, then Vₘₐₓ₁ < Vₘₐₓ₂, Vₘᵢₙ₁ < Vₘᵢₙ₂. Based on a big data statistics, if the resting time after the vehicle battery system is powered off is short, recovery (increase) degrees of voltage of all batteries are basically the same, then the longer the resting time after the battery is powered off of a cell and the smaller the recovery degree of voltage of the cell, or even the recovery degree of voltage is a negative value, it indicates that this cell has a problem of obvious self-discharge.

In another application scenario, the vehicle battery system is powered off in any working condition and enters a state without power consumption; then a monitor is waked up regularly, usually be waked up for a few minutes, and the power consumption in the wake-up state is very small, usually the current being only a few tenths of ampere, then it may be treated as the state without power consumption. This situation is similar to testing the self-discharge of a battery in the laboratory. The highest single-cell voltage and the lowest single-cell voltage are tested every once in a while, and a trend of voltage drop is analyzed. In theory, all single-cells have a weak self-discharge. Based on experience, within a short period of time, such as within 24 hours, the highest single-cell voltage remains unchanged. If the battery has the problem of self-discharge, then the lowest single-cell voltage shows a significant downward trend. In this way, a problem of abnormal self-discharge of a battery can be judged, and corresponding self discharge capacity, self-discharge energy, and self discharge current can be calculated.

For example: after a certain battery is powered off, the battery will self-wake up at an interval of *a* hour (*a* is usually greater than 1), and a duration of each wake-up is b hours (b is very small compared to a). At a time of first wake-up, the highest single-cell voltage is Vₘₐₓ₁, the lowest single-cell voltage is Vₘᵢₙ₁ and the corresponding state-of-charge of the battery is SOC_{high1} and SOC_{low1}. At this time, since the battery has been rested for *a* hours, it can be considered that the battery has been well depolarized. At a time of second wake-up, the highest single-cell voltage is Vₘₐₓ₂, the lowest single-cell voltage is Vₘᵢₙ₂ and the corresponding state-of-charge of the battery is SOC_{high2} and SOC_{low2}. Then within *a* hours, the self-discharge capacity of the battery is ((SOC_{low1} -SOC_{low2} ) - (SOC_{high1} -SOC_{high2}) ) × x₁, the self-discharge energy of the battery is ((SOC_{low1} -SOC_{low2}) - (SOC_{high1} -SOC_{high2} )) × e₁, and the average self-discharge current of the battery is ((SOC_{low1} -SOC_{low2} ) -(SOC_{high1} -SOC_{high2} )) × x₁/a. Since Vₘₐₓ₁ ≈ Vₘₐₓ₂, then SOC_{high1} ≈SOC_{high2}, and then the above formulas may be simplified as the self-discharge capacity of the battery is (SOC_{low1} - SOC_{low2}) × x₁, the self-discharge energy of the battery is (SOC_{low1} - SOC_{low2})× e₁, and the average self-discharge current of the battery is (SOC_{low1} - SOC_{low2}) × x₁ /a.

There is also an application scenario, in which a change law of electric quantity charged into the battery system corresponding to a SOC change per unit is calculated based on the SOC displayed by an instrument. A general practice in the industry, in order to avoid a problem of jumping change of the SOC for vehicle battery system as much as possible, the SOC displayed by the instrument will be following interrupted, high-end corrected, and low-end corrected during a use of the battery. As a certain cell or several cells in the battery system has/have the problem of abnormal self-discharge, the consistency of the battery system will deteriorate. The electric quantity of a full charge, a full discharge of the SOC displayed by the instrument from 0% electric quantity to 100% electric quantity will decrease. Considering that the battery system will not have obvious attenuation problems in a short period of time, if a charging electric quantity or a discharging electric quantity corresponding to the SOC displayed by the instrument has an obvious decreasing trend in a short period of time, it indicates that the battery has a significant problem of self discharge.

With this method, the advantages of big data of a cloud platform should be fully utilized, and a horizontal comparative analysis of all vehicle battery systems with the same model, the same service life, the same number of cycles, and the same SOH is implemented, to find out an electric quantity of charging or an electric quantity of discharging corresponding to an average SOC change per unit. In general, the BMS will report the electric quantity of charging to the cloud platform. The cloud platform can also perform an ampere-hour integration to calculate the electric quantity of charging or discharging.

In some embodiments, the electric quantities of charging or discharging corresponding to the SOC per unit of a certain vehicle battery system in history may be compared vertically. If there is a significant decrease within a short period of time (such as within 3 months), the battery of the vehicle can also be judged as having a significant problem of self-discharge.

If the electric quantity (capacity) of charging corresponding to the SOC per unit (1%SOC) of a vehicle battery system during a first charge process observed is 1 Ah (assuming that the rated capacity is 100 Ah and the rated energy is e), the electric quantity (capacity) of charging corresponding to the SOC per unit (1%SOC) of the vehicle battery system during a second charge process observed is 0.9 Ah, and a time interval between two charges is t₁, then it is judged that the battery has the problem of self discharge during this period of time; the self-discharge electric quantity (capacity) is (1-0.9) × 100=10 Ah, the self- discharge energy is (1-0.9) × 100 e, and the self-discharge current is (1-0.9) × 100/t₁ = 10/t₁.

In some embodiments, a detection for the problem of self discharge may also be performed based on data in a list of voltages. A list of voltages may have data uploaded to the cloud platform by manufacturers. Based on analysis methods in various embodiments and the data in the list of voltages, a distribution calculation may be performed on a self-discharge condition of each single-cell, then a cell with a largest current of self-discharge is identified and a pre-warning is given in advance, even if the cell is not a cell with a lowest voltage.

Example 1: in some embodiments, based on the list of voltages: the vehicle battery system is suddenly powered off from a working condition of high-rate discharging and enters a state without power consumption, and after a period of time t₁, the vehicle battery system is powered on again. The highest single-cell voltage is Vₘₐₓ₁ and the lowest single-cell voltage is Vₘᵢₙ₁ before the vehicle battery system is powered off; the highest single-cell voltage is Vₘₐₓ₂, the lowest single-cell voltage is Vₘᵢₙ₂ after the vehicle battery system is powered on again. As the vehicle battery system is discharged at a high rate before the vehicle battery system is powered off, the battery is polarized, and the vehicle battery system is depolarized after the vehicle battery system is rested for a period of time, thus Vₘₐₓ₁ < Vₘₐₓ₂, Vₘᵢₙ₁ < Vₘᵢₙ₂. If a recovery voltage of most cells is *a*, and the recovery voltage of one certain single-cell or several single-cells is significantly smaller than *a*, it is indicated that these several single-cells have the problem of self-discharge or a polarization voltage of these several single-cells is very small (equivalent to that the polarization internal resistance is very small). Compared with the above identification of self-discharge, this method can further prove that the cell has a problem of self-discharge.

Example 2: in some embodiments: the voltage of all single-cells after the end of first charge are V₁₁ /V₁₂ /V₁₃ ... V _{1N}, the average single-cell voltage is V ₁ₘₑₐ, and the corresponding state-of-charge of battery is SOC₁₁ / SOC₁₂ /SOC₁₃... SOC_{1N} /SOC₁ₘₑₐ respectively; the voltage of all single-cell s after the end of second charge are V₂₁ /V₂₂ /V₂₃ ... V _{2N}, the average single-cell voltage is V ₂ₘₑₐ, and the corresponding state-of-charge of battery is SOC₂₁ / SOC₂₂ /SOC₂₃... SOC_{2N} /SOC₂ₘₑₐ respectively; The time interval between two charges is t₁, and with the average single-cell voltage as the reference object, the corresponding currents of self-discharge are calculated respectively. For example, the self discharge capacity of a first cell is ((SOC ₁₁ -SOC ₂₁ )-(SOC ₁ₘₑₐ -SOC ₂ₘₑₐ )) × x₁, the self-discharge energy of the first cell is ((SOC ₁₁ -SOC ₂₁) - ( SOC ₁ₘₑₐ -SOC ₂ₘₑₐ )) × e₁, the average self-discharge current of the first cell is ((SOC ₁₁ -SOC ₂₁ ) - (SOC ₁ₘₑₐ -SOC ₂ₘₑₐ )) × x₁ /t₁.

In some embodiments, it is also possible to judge the problem of self discharge of a target vehicle battery and assess a risk of thermal runaway based on a cell temperature sensor. In theory, when a vehicle battery system is in a resting state and an outside atmospheric temperature is stable and uniform, a temperature of a battery will approach an air temperature, and a temperature difference caused by the charging and discharging of the battery and a non-uniformity of a thermal management system will tend to be smaller. However, if a certain cell has the problem of abnormal self-discharge, the discharged electric quantity will be converted into heat, which can increase the temperature of the cell. This is used as an auxiliary judgment measure for pre-warning of problem of self discharge of cell. At the same time, the magnitudes of the self-discharge current and the temperature are used as a reference for evaluating a risk of thermal runaway of the battery. The greater the self- discharge current and the higher a resting temperature, the greater the risk of thermal runaway of the battery. This method requires the battery system to have a temperature sensor on each cell to improve the accuracy of identification of temperature.

A pre-warning for a self-discharge of a vehicle battery system under different working conditions, different battery structures, and different states of consistency of all single-cells is realized according to the present invention by calculating the self discharge capacity, the self-discharge energy and the average self-discharge current value of the vehicle battery system based on different working condition states, different structural informations of batteries and different consistency informations of the vehicle battery system, and by judging whether the vehicle battery system is self-discharged based on the self discharge capacity, the self discharge energy and/or the average self-discharge current value, thereby the safety of the vehicle battery system and the user experience of passengers are greatly improved.

Please refer to FIG. 2, and FIG. 2 is a schematic structural diagram of a system of pre-warning for abnormal self-discharge of battery provided by an embodiment of the present invention. As shown in FIG. 2, a system of pre-warning for abnormal self-discharge of battery includes a state acquisition module 100, a data calculation module 200, a systematic judgment module 300 and a safety pre-warning module 400, wherein:

the state acquisition module 100 is configured for acquiring multiple extreme values of single-cell voltage, multiple extreme values of state-of-charge of single-cell and a time interval of adjacent data within the current working condition cycle of a vehicle battery system, based on a working condition information, a structural information and a consistency information of the vehicle battery system; the data calculation module 200 is configured for calculating a self discharge capacity, a self-discharge energy and an average self-discharge current value of the vehicle battery system based on the extreme values of single-cell voltage, the extreme values of state-of-charge of single-cell and the time interval of adjacent data; the systematic judgment module 300 is configured for judging whether the vehicle battery system is self-discharged according to whether any one of the self discharge capacity, the self-discharge energy and the average self-discharge current value is greater than a preset threshold value; and the safety pre-warning module 400 is configured for performing a pre-warning of battery safety based on a judgment result.

It can be understood that the system of pre-warning for abnormal self-discharge of battery provided in the present invention corresponds to the method of pre-warning for abnormal self-discharge of battery provided in the above-mentioned embodiments, and relevant technical features of the system of pre-warning for abnormal self-discharge of battery may refer to the relevant technical features of the method of pre-warning for abnormal self discharge of battery, which will not be repeated here.

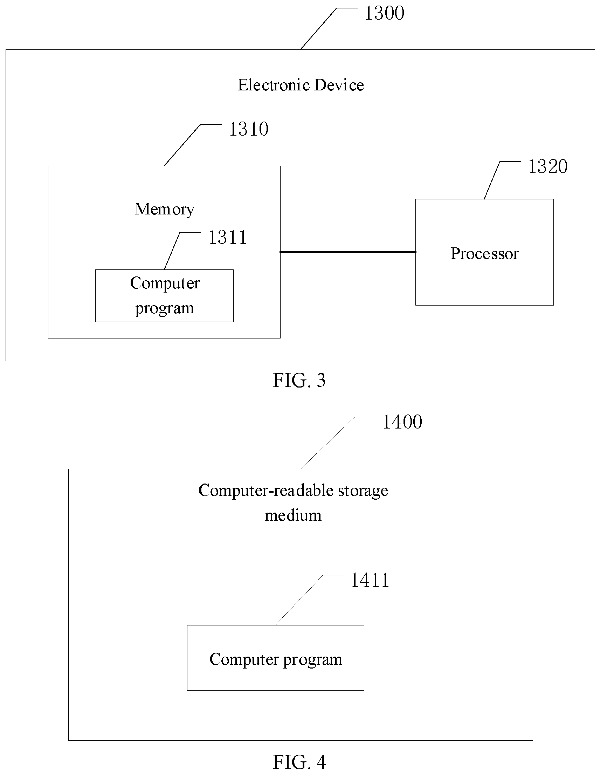

As shown in FIG. 3, FIG. 3 is a schematic diagram of a hardware structure of an electronic device provided in an embodiment of the present invention. As shown in FIG. 3, an embodiment of the present invention provides an electronic device, including a memory 1310, a processor 1320, and a computer program 1311 stored in the memory 1310 and runnable on the processor 1320; and the processor 1320, when performing the computer program 1311, implements the following steps :
acquiring multiple extreme values of single-cell voltage, multiple extreme values of state-of-charge of single-cell and a time interval of adjacent data within the current working condition cycle of a vehicle battery system, based on a working condition information, a structural information and a consistency information of the vehicle battery system; calculating a self-discharge capacity, a self discharge energy and an average self-discharge current value of the vehicle battery system based on the extreme values of single-cell voltage, the extreme values of state-of-charge of single-cell and the time interval of adjacent data; judging whether the vehicle battery system is self-discharged according to whether any one of the self-discharge capacity, the self-discharge energy and the average self-discharge current value is greater than a preset threshold value; performing a pre-warning of battery safety based on a judgment result.

As shown in FIG. 4, FIG. 4 is a schematic diagram of a hardware structure of a computer-readable storage medium provided by the present invention. As shown in FIG. 4, some embodiments provide a computer-readable storage medium 1400, on which a computer program 1411 is stored. The computer program 1411 implements, When executed by a processor, the following steps are implemented:
acquiring multiple extreme values of single-cell voltage, multiple extreme values of state-of-charge of single-cell and a time interval of adjacent data within the current working condition cycle of a vehicle battery system, based on a working condition information, a structural information and a consistency information of the vehicle battery system; calculating a self discharge capacity, a self discharge energy and an average self-discharge current value of the vehicle battery system based on the extreme values of single-cell voltage, the extreme values of state-of-charge of single-cell and the time interval of adjacent data; judging whether the vehicle battery system is self-discharged according to the self discharge capacity, the self-discharge energy and the average self-discharge current value; performing a pre-warning of battery safety based on a judgment result.

The present invention provides a method, system, electronic device, and storage medium of pre-warning for abnormal self-discharge of battery. The method includes: acquiring multiple extreme values of single-cell voltage, multiple extreme values of state-of-charge of single-cell and a time interval of adjacent data within the current working condition cycle of a vehicle battery system, based on a working condition information, a structural information and a consistency information of the vehicle battery system; calculating a self discharge capacity, a self discharge energy and an average self-discharge current value of the vehicle battery system based on the extreme values of single-cell voltage, the extreme values of state-of-charge of single-cell and the time interval of adjacent data; judging whether the vehicle battery system is self-discharged according to whether any one of the self-discharge capacity, the self-discharge energy and the average self-discharge current value is greater than a preset threshold value; performing a pre-warning of battery safety based on a judgment result. A pre-warning for a self-discharge of a vehicle battery system under different working conditions, different battery structures, and different states of consistency of all single-cells is realized by the present invention by calculating the self-discharge capacity, the self-discharge energy and the average self-discharge current value of a vehicle battery system based on the working condition information, the structural information and the consistency information of the vehicle battery system, and by judging whether the vehicle battery system is self-discharged based on the self-discharge capacity, the self discharge energy and/or the average self-discharge current value, thereby a safety of the vehicle battery system and a user experience of passengers are greatly improved.

It should be noted that, in the above-mentioned embodiments, the descriptions of each embodiment have their own emphases, and for parts that are not described in detail in a certain embodiment, reference may be made to relevant descriptions of other embodiments.

Those skilled in the art should understand that the embodiments of the present invention may be provided as methods, systems, or computer program products. Accordingly, the present invention can take the form of an entire hardware embodiment, an entire software embodiment, or an embodiment combining software and hardware aspects. Furthermore, the present invention may take the form of a computer program product embodied on one or more computer-usable storage media (including but not limited to disk storage, CD- ROM, optical storage, etc.) having computer-usable program code embodied therein.

The present invention is described with reference to a flowchart and/or block diagram of methods, equipments (systems), and computer program products according to embodiments of the present invention. It should be understood that each procedure and/or block in the flowchart and/or block diagram, and a combination of procedures and/or blocks in the flowchart and/or block diagram can be realized by computer program instructions. These computer program instructions may be provided to a general-purpose computer, special-purpose computer, embedded processor, or processor of other programmable data processing device to produce a machine, such that the instructions, executed by the processor of the computer or other programmable data processing device, produce a device for realizing the functions specified in one or more procedures of the flowchart and/or one or more blocks of the block diagram.

These computer program instructions may also be stored in a computer-readable memory capable of directing a computer or other programmable data processing device to operate in a specific manner, such that the instructions stored in the computer-readable memory may produce an article of manufacture including an instruction device. The instruction device realizes the function specified in one or more procedures of the flowchart and/or one or more blocks of the block diagram.

These computer program instructions can also be loaded onto a computer or other programmable data processing device, so as to cause a series of operational steps to be performed on the computer or other programmable device to produce a computer-implemented process, thereby the instructions, executed on a computer or other programmable device, provide steps for implementing the function specified in one or more procedures of the flowchart and/or one or more blocks of the block diagram.

Although preferred embodiments of the present invention have been described, additional changes and modifications can be made to these embodiments by those skilled in the art once the basic inventive concept is appreciated. Therefore, it is intended that the appended claims be construed to cover the preferred embodiments and all changes and modifications which fall within the scope of the present invention.

It is obvious that those skilled in art can make various changes and modifications to the present invention without departing from the spirit and scope of the present invention. Thus, if these modifications and variations of the present invention fall within the scope of the claims of the present invention and equivalent technologies thereof, the present invention also intends to include these modifications and variations.

## Claims

1. A method of pre-warning for abnormal self discharge of battery, **characterized by** comprising:
acquiring multiple extreme values of single-cell voltage, multiple extreme values of state-of-charge of single-cell and a time interval of adjacent data within a current working condition cycle of a vehicle battery system, based on a working condition information, a structural information and a consistency information of the vehicle battery system;
calculating a self discharge capacity, a self discharge energy and an average self-discharge current value of the vehicle battery system based on the extreme values of single-cell voltage, the extreme values of state-of-charge of single-cell and the time interval of adjacent data;
judging whether the vehicle battery system is self-discharged according to whether any one of the self discharge capacity, the self-discharge energy and the average self-discharge current value is greater than a preset threshold value; and
performing a pre-warning of battery safety based on a judgment result.

2. The method of pre-warning for abnormal self-discharge of battery according to claim 1, wherein, the step of calculating a self-discharge capacity, a self discharge energy and an average self-discharge current value of the vehicle battery system based on the extreme values of single-cell voltage, the extreme values of state-of-charge of single-cell and the time interval of adjacent data, comprises:
acquiring a first time interval between ends of two charges in the case that the working condition information is a state of end of charge, the consistency information is an idealized state, and the structural information is that cell-groups are made up of an individual cell and various cell-groups are connected in series therebetween, or the cell-groups are made up of a plurality of cells and various cell-groups are connected in series therebetween; wherein, the idealized state is that a difference value between a lowest single-cell voltage and a highest single-cell voltage after an end of previous charge is less than or equal to a preset difference value;
acquiring the extreme values of state-of-charge of single-cell after an end of latter charge; wherein the extreme values of state-of-charge of single-cell comprises a maximum value of state-of-charge of single-cell and a minimum value of state-of-charge of single-cell;
acquiring a first difference of extrema based on the maximum value of state-of-charge of single-cell and the minimum value of state-of-charge of single-cell after the end of latter charge; and
calculating the self-discharge capacity, the self-discharge energy, and the average self-discharge current value of the vehicle battery system according to the first difference of extrema, a rated capacity of single-cell, a rated energy of single-cell, and the first time interval.

3. The method of pre-warning for abnormal self-discharge of battery according to claim 2, further comprising:
acquiring a second time interval between the ends of two charges, in the case that the working condition information is the state of end of charge, the structural information is that the cell-groups are made up of an individual cell and various cell-groups are connected in series therebetween, and the consistency information is a non-idealized state; wherein, the non-idealized state is that a difference value between the lowest single-cell voltage and the highest single-cell voltage after the end of previous charge is greater than the preset difference value;
acquiring a difference value between the minimum values of state-of-charge of single-cell after the end of previous charge and after the end of latter charge as a second difference of extrema;
calculating the self-discharge capacity, the self-discharge energy, and the average self-discharge current value of the vehicle battery system according to the second difference of extrema, the rated capacity of single-cell, the rated energy of single-cell, and the second time interval.

4. The method of pre-warning for abnormal self-discharge of battery according to claim 2, further comprising:
acquiring a third time interval between the ends of two charges in the case that the working condition information is a state of discharge, the consistency information is the idealized state, and the structural information is a single-parallel & multiple-series;
acquiring the extreme values of state-of-charge of single-cell after an end of latter charge;
acquiring a third difference of extrema based on the maximum value of state-of-charge of single-cell and the minimum value of state-of-charge of single-cell after the end of latter charge; and
calculating the self-discharge capacity, the self-discharge energy, and the average self-discharge current value of the vehicle battery system according to the third difference of extrema, the rated capacity of single-cell, the rated energy of single-cell, and the third time interval.

5. The method of pre-warning for abnormal self-discharge of battery according to claim 4, further comprising:
acquiring a fourth time interval between the ends of two charges in the case that the working condition information is the state of discharge, the consistency information is the idealized state, and the structural information is a multiple-parallel & multiple-series;
acquiring the extreme values of state-of-charges of single-cells after the ends of two charges;
acquiring a fourth difference of extrema based on the lowest single-cell voltage and the highest single-cell voltage after the end of previous charge;
acquiring a fifth difference of extrema based on the lowest single-cell voltage and the highest single-cell voltage after the end of latter charge;
taking a difference value between the fourth difference of extrema and the fifth difference of extrema as a sixth difference of extrema; and
calculating the self-discharge capacity, the self-discharge energy, and the average self-discharge current value of the vehicle battery system according to the sixth difference of extrema, the rated capacity of single-cell, the rated energy of single-cell, and the fourth time interval.

6. The method of pre-warning for abnormal self-discharge of battery according to claim 2, further comprising:
acquiring a fifth time interval between two resting states within a corresponding period of time which is greater than a preset threshold value for resting duration in the case that the working condition information is the resting state and a resting duration is greater than or equal to the preset threshold value for resting duration;
acquiring the extreme values of state-of-charges of single-cells under the two resting states;
acquiring a seventh difference of extrema based on the lowest single-cell voltage and the highest single-cell voltage in previous resting state;
acquiring an eighth difference of extrema based on the lowest single-cell voltage and the highest single-cell voltage in latter resting state;
taking a difference value between the eighth difference of extrema and the seventh difference of extrema as a ninth difference of extrema; and
calculating the self-discharge capacity, the self-discharge energy, and the average self-discharge current value of the vehicle battery system according to the ninth difference of extrema, the rated capacity of single-cell, the rated energy of single-cell, and the fifth time interval.

7. The method of pre-warning for abnormal self-discharge of battery according to claim 1, further comprising:
acquiring an amplitude of voltage drop or a recovery degree of voltage of the extreme values of single-cell voltage of the vehicle with different service lives, different charging rates and different resting durations without power consumption, and judging, based on the amplitude of voltage drop or the recovery degree of voltage, whether the vehicle battery system is self-discharged.

8. A system of pre-warning for abnormal self discharge of battery, comprising:
a state acquisition module, configured for acquiring multiple extreme values of single-cell voltage, multiple extreme values of state-of-charge of single-cell and a time interval of adjacent data within a current working condition cycle of a vehicle battery system, based on a working condition information, a structural information and a consistency information of the vehicle battery system;
a data calculation module, configured for calculating a self discharge capacity, a self discharge energy and an average self-discharge current value of the vehicle battery system based on the extreme values of single-cell voltage, the extreme values of state-of-charge of single-cell and the time interval of adjacent data;
a systematic judgment module, configured for judging whether the vehicle battery system is self-discharged according to whether any one of the self-discharge capacity, the self-discharge energy and the average self-discharge current value is greater than a preset threshold value; and
a safety pre-warning module, configured for performing a pre-warning of battery safety based on a judgment result.

9. An electronic device, comprising a memory and a processor, wherein the processor is configured to, when executing a computer management program stored in the memory, implement steps of the method of pre-warning for abnormal self-discharge of battery according to any one of claims 1-7.

10. A computer-readable storage medium, wherein the computer-readable storage medium is stored with a computer management program, and the computer management program implements, when executed by a processor, steps of the method of pre-warning for abnormal self-discharge of battery according to any one of claims 1-7.
